(19) Europäisches Patentamt
European Patent Office
Office européen des brevets

(11) **EP 2 075 912 A1**

(12) **EUROPEAN PATENT APPLICATION**

(43) Date of publication:
**01.07.2009 Bulletin 2009/27**

(51) Int Cl.:
*H03H 17/02* (2006.01)     *H03M 1/12* (2006.01)

(21) Application number: **07021850.8**

(22) Date of filing: **10.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Institute of Electronics and Computer Sciences**
**Riga 1006 Lettland (LV)**

(72) Inventors:
• **Artjuhs, Jurijs**
**Riga LV-1006 (LV)**
• **Bilinskis, Ivars**
**Riga, LV-1006 (LV)**
• **Sudars, Kaspars**
**Riga, LV-1006 (LV)**

(74) Representative: **Klickow, Hans-Henning**
**Patentanwälte**
**Hansmann-Klickow-Hansmann**
**Jessenstrasse 4**
**22767 Hamburg (DE)**

(54) **Method for complexity-reduced digital filtering and parameter estimation of analog signals**

(57)     A method for digital filtering and parameter estimation of an analog input signal is comprising:
generating a sinusoidal reference function of a given amplitude, phase angle and frequency outside the frequency range of the analog input signal to be digitally filtered; comparing said input signal with said reference function and detecting the time instants of their crossings; converting said time instants of the signal and reference crossings into their digital values and forming a digital signal as a sequence of digital said crossing instant values representing said input signal digitally; generating a template for calculation of the filtered signal instantaneous values by amplitude-modulating the sinusoidal reference function with the required filter impulse response as a tool for filtering out the input signal components within the required pass-band; positioning said template so that its middle point coincides in time with the instantaneous value of the filter output signal to be calculated; sampling of said properly positioned template at the time instants corresponding to the digital signal representation of said input signal; calculating the respective instantaneous values of the filter output signal as the mean value of said sampled values of said template; initiating the following cycles of filtering by shifting said template into the position for estimation the next output signal instantaneous value, sampling the template and averaging the sampled values of the template for obtaining the following instantaneous values of the filter output signal.

EP 2 075 912 A1

**Description**

The present invention relates generally to the field of original analog signal digitisation, representation of the original signals by digital signals and their digital processing. More specifically the present invention addresses the problem of the complexity and power consumption reduction for systems performing signal digitising, digital filtering and parameter estimation functions.

The invented method provides for complexity-reduced digital filtering, including Discrete Fourier Transforms, and estimation of various signal parameters based on such filtering. According to it, signal digital representation is special, adapted to the needs of the invented digital filtering in a way making it possible to avoid multiple multiplications of multi-digit numbers usually carried out in the course of the signal filtering and their parameter estimation processes. Such massive multiplications, leading to significant consumption of computation time and energy, usually have to be performed whenever discrete sample value sequences of the signals being processed are used for their digital representation. The invented method makes it possible to avoid them. Essentially different digital representation, based on either digital or analog timing of the signal and the reference sine-wave crossing instants is used and that leads to significant simplification of the digital filtering process. It is performed as a much simpler operation of moving averaging of sample values of specifically defined filtering template.

The invented method provides also for on-line filtering, in particular, for continuous estimation of Fourier coefficients. In that case the filtering could be performed by digitising the sample values of the filtering template rather than the signal and the reference sine-wave crossing instants, avoiding the typically used signal analog-digital conversions completely.

The digital signal representation appropriate for the invented multiplier-less signal filtering is well suited also for realization of remote data acquisition from a large number of signal sources.

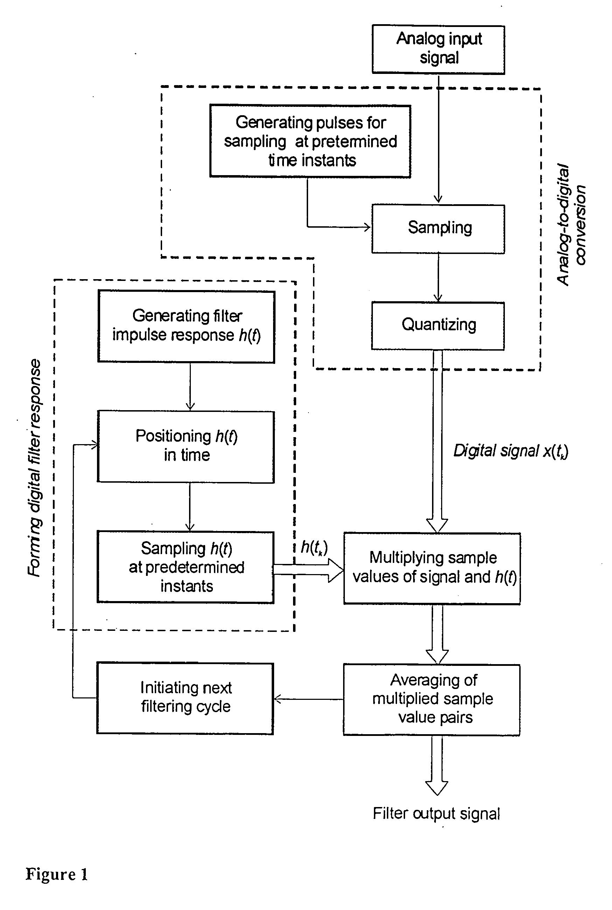

The conventional method for digital filtering of an analog input signal comprises the following operations performed according to the diagram given in Figure 1:

   a) generating of pulses for sampling the analog input signal at predetermined time instants;
   b) analog/digital (A/D) conversions of the multiplexed signal and forming the digital signal representing the analog input signal, including sampling of said input signal at predetermined instants and quantising of the obtained sample values (usually done in very close vicinity, typically within a single chip);
   c) generating of the filter impulse response function providing for the required digital signal filtering;
   d) positioning of said response function so that its middle point coincides in time with the instantaneous value of the filter output signal to be calculated;
   e) sampling of said response function properly positioned in time at predetermined time instants;
   f) multiplying of sample values of said digital signal and said response function taken at the same time instants;
   g) calculating of an instantaneous value of the filter digital output signal signal as the mean value of the multiplied pairs of sample values of the digital input signal and the sampled filter response function;
   h) starting filtering of the next output signal value by shifting the response function so that its middle point coincides in time with this next instantaneous value of the filter and repeating all other said filtering operations.

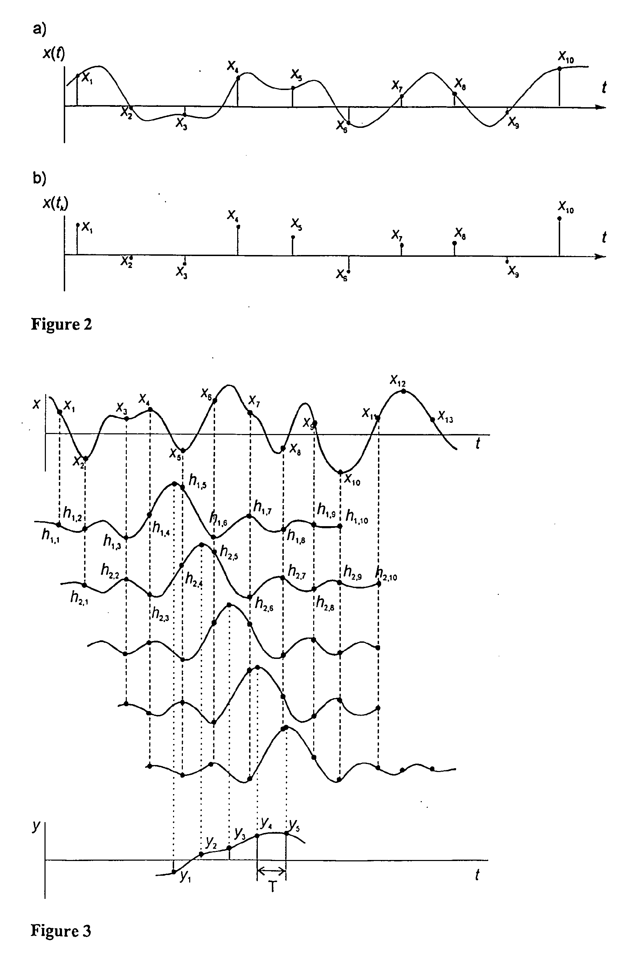

Figures 2 and 3 illustrate this conventionally method for digital representation of signals and their non-recursive filtering. Figure 2 illustrates typical approach to analog/digital conversions. The digital signal {x(tk)} formed in result of them is given as a sequence of quantised signal sample values taken periodically or nonuniformly at predetermined signal-independent time instants{tk}.

Diagrams in Figure 3 illustrate the conventional method for digital filtering of such digital signals. According to these diagrams, an original continuous time or analog signal x(t) is sampled at signal-independent time instants {tk}, the sample values taken are quantized and then the sequence {x(tk)} of the sampled and quantized signal sample values is used for the digital representation of this signal. To filter this signal, the output signal values are calculated as weighted sums of a limited number of the input signal sample values multiplied by the corresponding digital values h(tn) of the filter response function h(t). This function is positioned so that its peak coincides in time with the respective instantaneous value of the filtered signal. Using the notation given in Figure 3, the first instantaneous value of the filtered signal is obtained by sampling the response function, multiplying the sample values of the signal with the respective sample values and summing up all particular multiplied sample value pairs. We can write that the first sample value of therefore filter output signal

$$y_1 = h_{1,1}x_1 + h_{1,2}x_2 + h_{1,3}x_3 + ... + h_{1,m}x_m \qquad (1)$$

In the particular case illustrated in Figure 3, the value of m=10.

To obtain the second value of the filtered output signal, the response h(t) is shifted to the right for a time interval equal to the sampling interval of the output signal y(tj), which in the discussed case is equal to T. The second sample value of the filtered signal is

$$y_2 = h_{2,1}x_2 + h_{2,2}x_3 + h_{2,3}x_4 + ... + h_{2,m}x_{m+1} \qquad (2)$$

In general, the sample values of the impulse response h(t) used for calculations of y1, y2 and the following values y3, y4, y5, ... differ. While the output signal values in the illustrated case are spaced uniformly, this is not compulsory. If the impulse response is shifted irregularly, the output signal is represented by a corresponding irregular sequence of the sample values.

As can be seen from equations (1) and (2), the most computationally burdensome operations at such digital filtering of signals represented by their quantised sample values are the multiplications of the multi-digit sample values of the response function and the input signal. This approach to digital signal processing, in particular to non-recursive filtering, is the basically and the most often used one. It is described, for instance, in [1].

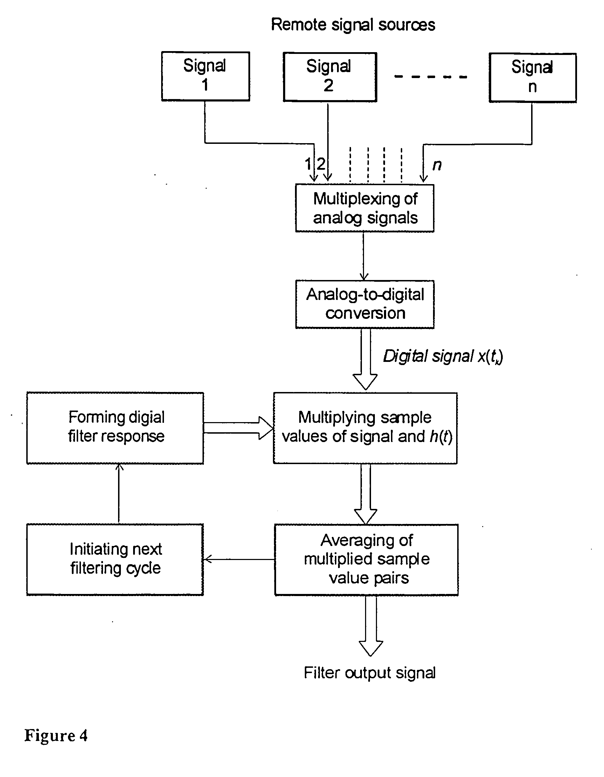

There are a lot of data acquisition systems operating according to these principles. To illustrate the situation with the prior art, let us refer to some of systems of this kind. Typical example of such systems is a general-purpose USB-based DAQ module PMD-1208FS from "Measurement Computing" [2]. It provides 4 differential or 8 single-ended analog inputs, up to 12-bit A/D resolution, 50 kS/s sampling rate. However, most of similar data acquisition blocks have relatively large size and for this reason they are usually located at a distance from the sensors and that often leads to spurious distortions of the analog signals in the connecting lines. In addition, the number of analog inputs is usually limited to a few tens. Figure 4 illustrates the prior art method applied for digital filtering of a number of analog input signals multiplexed according to the method for time-division multiplexing.

More advanced techniques for data acquisition use almost the same principles of operation but in this case each data acquisition block is implemented as a low power compact device (named "sensor node") that supports a wireless data transmitting. A typical example of such a sensor node is the Multi-Channel Strain Transmitter from "Strain-Link" [3]. It has the size of a postage stamp, needs only 8.7 mW powering (including RF link), supports 3 fully differential inputs, has 10 bit A/D resolution and up to 1 kS/s sampling rate.

Realization of all the mentioned signal digitisation and data acquisition procedures leads to high technical complexity of the structures supporting them. Consequently the operation of these structures typically is characterised by relatively high power consumption. The procedures related to processing of the acquired data typically are also complicated and the methods for signal filtering and their parameter estimation typically are based on performance of a large quantity of repetitious multiplications. The necessity of performing these computationally burdensome calculations at digital processing of signals, including filtering and estimation of various signal parameters based on such filtering, is a substantial drawback of the conventional methods for the digital signal representation and processing.

Thus the main problem is the complexity reduction of signal digital representation and processing carried out specifically for the signal filtering and their parameter estimation.

The present invention addresses the problem of reducing the complexity of analog input signal digital filtering and parameter estimation by representing the said signals as a sequence of crossing events of the said input signal and a generated sinusoidal reference function timed either in digital or analog form. A wide variety of signals are converted in this way into a specifically sampled sinusoidal function characterized by a given frequency, amplitude and phase angle making it possible to perform digital filtering of the said digital signals by using the required filter impulse response function for modulating said sinusoidal function, sampling of it at the time instants according to the digital representation of said input signal with subsequent calculations of the instantaneous values of the filter output signals as averages of the sample values of the said modulated sinusoid. This results in invention of the method for signal complexity-reduced digital filtering and parameter estimation eliminating repetitious multiplications of a large quantity of multi-digit numbers required in the prior art case.

The invented method for digital filtering of analog signals covers analog input signal conversion into the respective digital signal that is defined as a sequence of time instants indicating crossings of the said input signal and a sinusoidal reference function, characterized by a given frequency, amplitude and phase angle, and filtering of said digital signal performed as averaging of sample values of said sinusoidal reference function modulated by the required filter impulse response.

A primary object of the present invention is to provide a method for signal digital representation leading to the complexity reduction of filtering and parameter estimation operations achieved by eliminating multiplications of the signal instantaneous values with the respective sample values of the filter impulse response function.

A secondary object of the present invention is to provide for the reduction of the complexity and power consumption related to the analog operations that are performed close to the multiple signal sources for remote multi-channel digitizing of the signals taken from the said sources.

DETAILED DESCRIPTION OF THE INVENTION

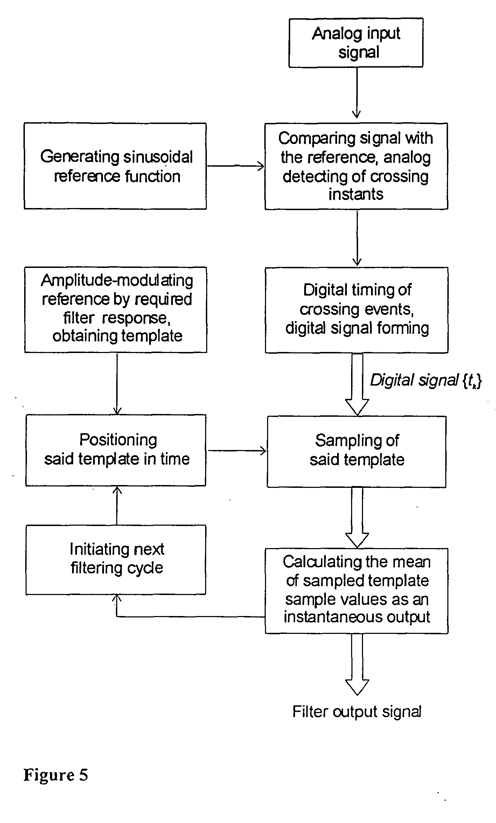

Figure 5 provides a block diagram illustrating the analog-to-digital conversion of the input signal and complexity-reduced filtering of the obtained digital signal represented by a sequence of timed input signal and a reference function crossing events. As compared to the Figure 1, there are substantial differences in the approach to both the analog-to-digital conversions and filtering.

The invented method for analog input signal digital filtering and parameter estimation comprises:

a) generating of a sinusoidal reference function of a given amplitude, phase angle and frequency with this frequency outside the frequency range of the analog input signal to be digitally filtered ;

b) comparing said input signal with said reference function, detecting the time instants of their crossings;

c) digitally timing said time instants of the signal and reference crossings and forming a digital signal as a sequence of digital said crossing instant values representing said input signal digitally;

d) generating a template for calculation of the filtered signal instantaneous values by amplitude-modulating the sinusoidal reference function with the required filter impulse response (according to the given expression (6)) as a tool for filtering out the input signal components within the required pass-band;

e) positioning said template so that its middle point coincides in time with the instantaneous value of the filter output signal to be calculated;

f) sampling of said properly positioned template at the time instants dictated by the digital signal representation of said input signal;

g) calculating the respective instantaneous values of the filter output signal as the mean value of said sampled values of said template;

h) initiating the following cycles of filtering by shifting said template into the position for estimation the next output signal instantaneous value, sampling the template and averaging the sampled values of the template for obtaining the following instantaneous values of the filter output signal.

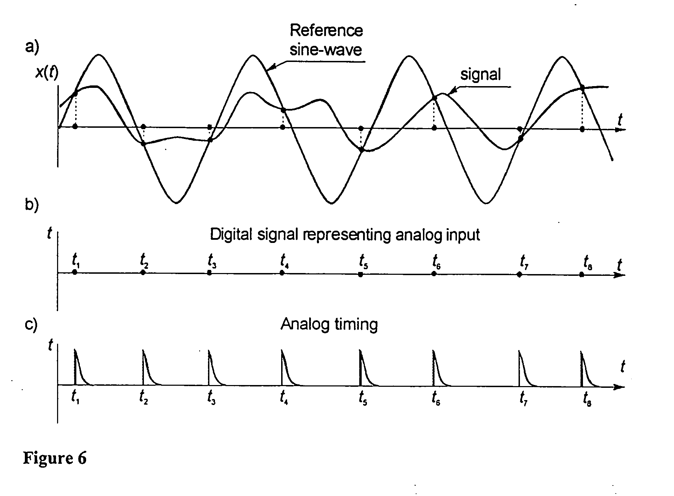

The analog input signal, before filtering, is converted into its digital counterpart. The essence of the digital representation of analog input signals, used for achieving the basic objective of the considered invention, is illustrated in Figure 6. While usually the digital signal is formed as a sequence of the original analog signal sample values x1, x2, x3, ..., in the present invention, to achieve the complexity reduction of the subsequent filtering process, the sampling operation is performed as shown in Figures 6(a) and 6(b). Specifically, a sinusoidal reference function is generated and the analog input signal is digitally represented as a sequence of time instants when the events of the input signal and the reference function crossings occur. This specific digital signal fully represents the analog input signal. Indeed, as all types of input signals, with their maximal values restricted below the amplitude of the reference function and spectra appropriately limited in the frequency domain, are converted into a sampled sinusoidal waveform characterized by a given frequency fr, amplitude Ar and phase angle φr of the reference function. The information carried by the original analog input signal is transferred to this specific digital signal. It is fully reflected by the points indicated on the time axis as shown in Figure 6 (b). These points indicate the time instants {tk} when the crossing events of the said signal and reference function happen. As the sample values of the reference sinusoid depend exclusively on the signal and reference crossing instants, these sample values are redundant. Therefore the digital representations of the original analog input signals can be given in the form of this type of digital point processes shown in Figure 6(b). Thus the digital representation {tk} of the input signal x(t) is based on timing information rather than on the sample values {x(tk)} of the said signal. As the parameters fr, Ar and φr of the reference sine-wave function are a priori given, the original signals could be reconstructed from such point processes $\{t_k\}$.

The fact that input signals, in the case of the invented method, invariably are represented by the sampled reference sinusoid, characterized by its frequency fr, amplitude Ar, and phase angle φr, makes it possible to transform the expressions typically used as the basis for digital filtering.

To demonstrate this, the typically used approach to filtering might be compared with the invented method. In the case where filtering is carried out according to the conventional method, the digital filter typically used for extracting the i-th frequency from the input signal x(tk) is characterized by a response function given as

$$h(t) = \sin 2\pi f_i t \qquad (1)$$

The estimate of a sample value $y(t_n)$ of the output signal of such a selective digital filter is calculated as follows:

$$y(t_n) = \frac{2}{N}\sum_{k=0}^{N-1} x_k h(t_k) = \frac{2}{N}\sum_{k=0}^{N-1} x_k \sin 2\pi f_i t_k \qquad (2)$$

Apparently N multiplications of the multi-digit numbers representing the sample values of the input signal x(tk) and the response function (1) have to be carried out to obtain this particular estimate of the respective single instantaneous value y(tn) of the filter output signal.

The invented method makes it possible to obtain the same estimate without execution of these N multiplication operations.

The invented method for the complexity-reduced filtering exploits the fact that the digital representation of the input signal is a reference sinusoid of a fixed amplitude, frequency and phase angle sampled at time instants depending on the input signal. This fact allows using of the respective sampling instant sequence as the digital signal representing the said input signal and leads to the possibility of transforming the procedure of the considered selective filtering. If Ar = 1, where Ar is the amplitude of the reference signal, then the estimation of the sample value y(tn) of the output signal of the selective digital filter extracting the i-th frequency according to the invented method is based on the following equation:

$$y(t_n) = \frac{2}{N}\sum_{k=0}^{N-1} \sin 2\pi f_r t_k \sin 2\pi f_i t_k \qquad (3)$$

It reflects the fact that the required filter response is used for amplitude modulation of the reference function and that each instantaneous value of the output signal is calculated as the mean value of this amplitude modulated waveform.

Evidently equation (3) can be converted and given as:

$$y(t_n) = \frac{1}{N}\sum_{k=0}^{N-1}\cos 2\pi\left(f_r - f_i\right)t_k - \cos 2\pi\left(f_r + f_i\right)t_k = \frac{1}{N}\sum_{k=0}^{N-1} xh(t_k) \qquad (4)$$

This equation (4) means that filtering according to the invented method is simply reduced to averaging the sample values xh(tk) taken from the following function at the discrete time instants {tk} digitally representing the input signal:

$$xh(t) = \cos 2\pi\left(f_r - f_i\right)t - \cos 2\pi\left(f_r + f_i\right)t \qquad (5)$$

As this function is derived as a product of the multiplied generalized input signal waveform and the filter response function, it is denoted as xh(t), it is called and considered as a template for calculating the sample values of the filter output signal. The dimension of the instantaneous values xh(tk) of this template xh(t) is equal to the dimension of the respective input signal.

This approach to filtering, in general, holds also for other types of filtering performed on the basis of more complicated filter response functions. That is how the digital representations of the input signals might be filtered and processed without performing a large quantity of repetitious multiplications of multi-digit numbers as it is in the prior art case.

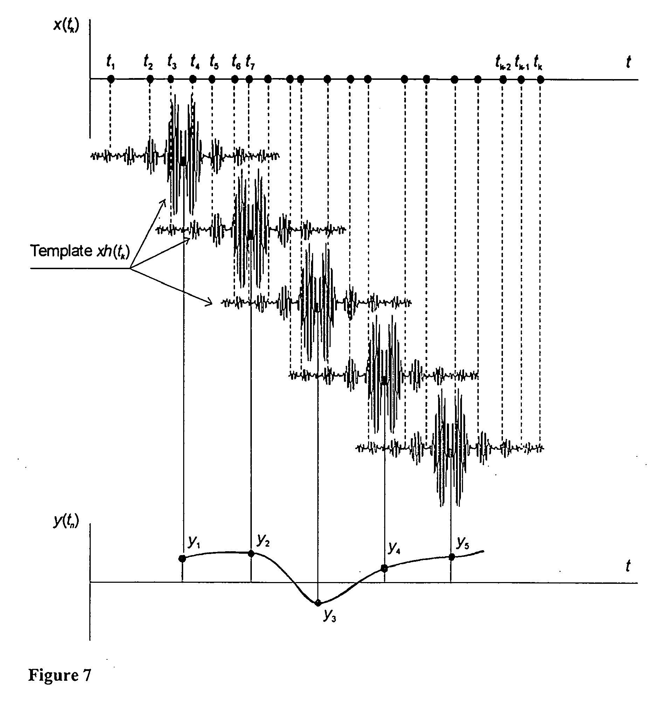

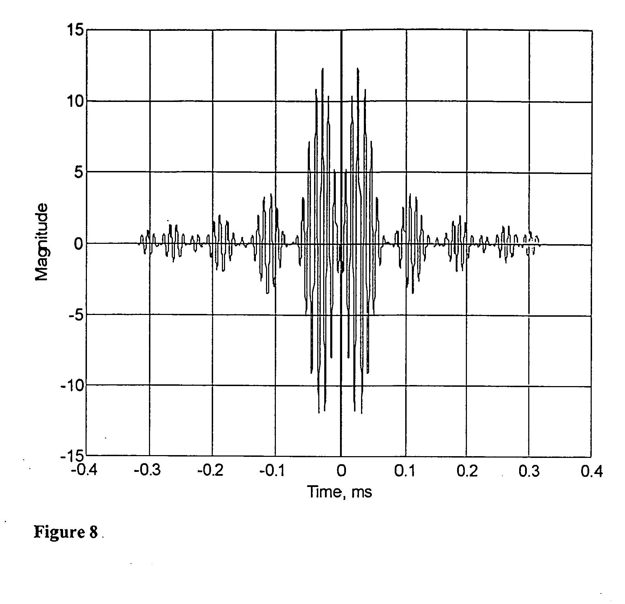

Figure 7 illustrates low-pass filtering performed according to the invented method. The template xh(t), given in Figure 8, in this case is composed from a multiple cosine functions at frequencies covering the given filter pass-band M$\Delta$f with sufficiently small frequency steps $\Delta$f as follows:

$$xh(t) \doteq \frac{1}{M} \sum_{i=1}^{M} \left[ \cos 2\pi \left( f_r - i\Delta f \right) t - \cos 2\pi \left( f_r + i\Delta f \right) t \right], \quad i = 1, 2, \ldots, M \quad (6)$$

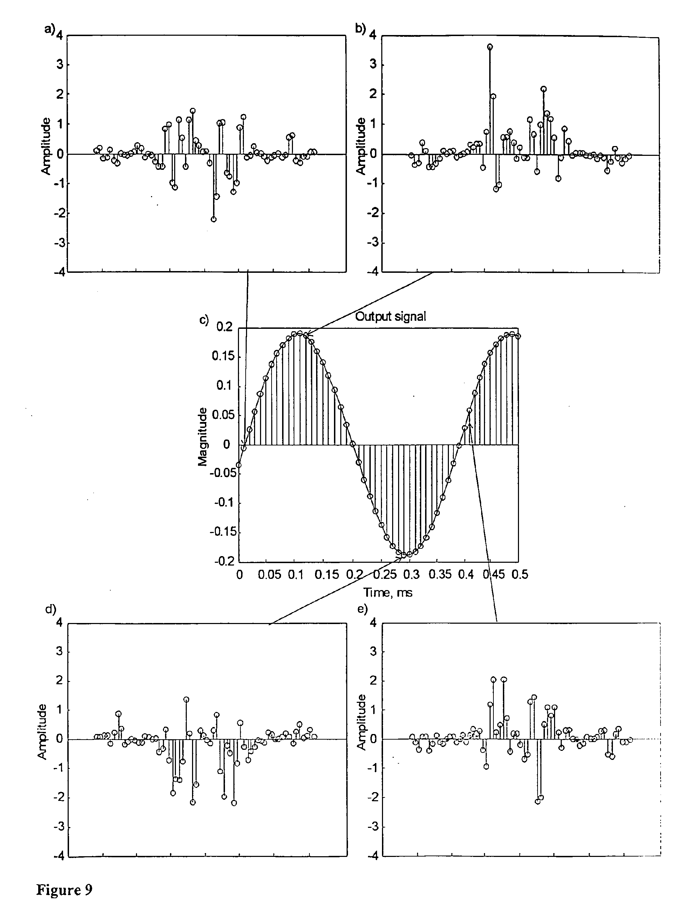

To filter the input signal according to the invented method as shown in Figure 7, it is digitally represented by the sequence of the signal and the reference function crossing instants {tk}, the template xh(t) is derived and it is limited in time so that its length is equal to the time interval $\Theta$ during which the input signal is observed. For performing the filtering operation, the time-limited xh(t) is positioned on the time axis so that the time coordinate of its peak coincides with time instant tn for which the instantaneous value yn of the filter output signal is to be calculated, said template xh(t) is sampled at the time instants belonging of the row {tk} which fall within the time interval $\Theta$ covered by said template xh(t) and then calculate the output signal instantaneous value yn directly below the peak of said template xh(t) is calculated as the average value of the particular set of the sample values xh(tk) of the template corresponding to the given position of xh(t) on the time axis. To obtain the next output signal value yn+1, said template is shifted to the right for a time step $\Delta$t so that its peak is positioned at the time instant tn+1, it is again sampled at respective time instants as shown in Figure 7 and the value of yn+1 is calculated by averaging the respective set of the sample values xh(tk). Figure 9 illustrates this calculation of output signal individual values. The filtered out signal is given in Figure 9 (c) and sampled templates are shown in Figure 9 (a), (b), (d) and (e). Averaged values of these sampled templates represent the indicated instantaneous values of the output signal in Figure 9 (c).

The invented method covers also the estimation of various signal parameters. Specifically, the selective filter, described by (4), can be directly used for spectrum analysis of signals based on Discrete Fourier Transforms. The said filter can be used for calculation of the Fourier coefficients and for the estimation of various signal parameters that are defined as derivatives of the said Fourier coefficients, for instance, amplitudes, phase angles and power of the signal components at various arbitrary frequencies.

The estimation of the Fourier coefficients, performed according to the invented method, is reduced to obtaining the row of the time instants {tk}, indicating the signal and the reference function crossings, forming of a matrix of sine and cosine function sample values at frequencies fr$\pm$fi and to calculation of the Fourier coefficient estimates simply by averaging these sample values according to the following equations:

$$\left\{\begin{array}{l} \dfrac{1}{N}\left[\phi_1(t_1)+\phi_1(t_2)+\ldots+\phi_1(t_k)+\ldots+\phi_1(t_N)\right]=\hat{a}_1(f_1) \\[2mm] \dfrac{1}{N}\left[\psi_1(t_1)+\psi_1(t_2)+\ldots+\psi_1(t_k)+\ldots+\psi_1(t_N)\right]=\hat{b}_1(f_1) \\[2mm] \dfrac{1}{N}\left[\phi_2(t_1)+\phi_2(t_2)+\ldots+\phi_2(t_k)+\ldots+\phi_2(t_N)\right]=\hat{a}_2(f_2) \\[2mm] \dfrac{1}{N}\left[\psi_2(t_1)+\psi_2(t_2)+\ldots+\psi_2(t_k)+\ldots+\psi_2(t_N)\right]=\hat{b}_2(f_2) \\[2mm] \ldots\ldots\ldots\ldots\ldots\ldots\ldots\ldots\ldots\ldots\ldots\ldots\ldots\ldots\ldots\ldots\ldots\ldots\ldots\ldots\ldots\ldots\ldots\ldots \\[2mm] \dfrac{1}{N}\left[\phi_M(t_1)+\phi_M(t_2)+\ldots+\phi_M(t_k)+\ldots+\phi_M(t_N)\right]=\hat{a}_M(f_M) \\[2mm] \dfrac{1}{N}\left[\psi_M(t_1)+\psi_M(t_2)+\ldots+\psi_M(t_k)+\ldots+\psi_M(t_N)\right]=\hat{b}_M(f_M) \end{array}\right.$$

(7)

where

$$\phi_i(t_k)=\sin 2\pi(f_r-f_i)t_k+\sin 2\pi(f_r+f_i)t_k, \quad \text{i=1, 2, 3, ..., M;}$$
k=1, 2, 3, ..., N;　　　　　　　　　(8)

and

$$\psi_i(t_k)=\cos 2\pi(f_r-f_i)t_k-\cos 2\pi(f_r+f_i)t_k, \quad \text{i=1, 2, 3, ..., M;}$$
k=1, 2, 3, ..., N　　　　　(9)

The benefit obtainable by using the invented method for this kind of signal spectrum analysis and estimation of parameters of the signal spectral components evidently is elimination of a large quantity of multi-digit number multiplications. In addition, the signal spectrum analysis can be carried out in this multiplier-less way at arbitrary frequencies what cannot be said about the Fast Fourier Transform algorithms.

Estimates of the signal mean value mx and the mean power P might be mentioned as additional examples of other signal parameters that can be estimated on the basis of the invented method simply by averaging sample values of a certain function hm(t) or hP(t) taken at the time instants {tk}. The following formulae should be used for that:

$$\hat{m}_x=\frac{1}{N}\sum_{k=1}^{N}h_m(t_k) \quad \text{where} \quad h_m(t)=\sin 2\pi f_r t_k$$

(10)

$$\hat{P} = \frac{1}{N} \sum_{k=1}^{N} h_P(t_k) \qquad \text{where} \qquad h_P(t) = \sin^2 2\pi f_r t_k \qquad (11)$$

where fr is the frequency of the sinusoidal reference function.

The digital signal being processed is the sequence of time instants {tk} indicating the events of the original analog input signal and the said reference function crossings. The functions hm(t) and hP(t) are signal independent.

In general, the digital signal representing the original analog signal to be filtered according to the invented method is formed at the instants of the signal and the reference function crossings. This invention might be used under varying conditions, including conditions typical for digital filtering of signals originating at remote single or multiple signal sources.

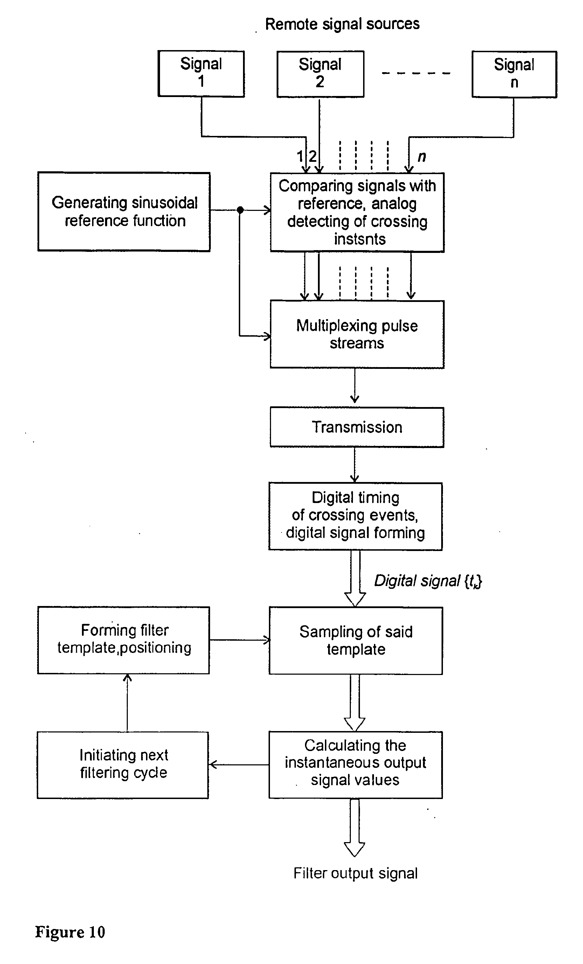

Analog-to-digital conversion of an original analog signal performed according to the invented method can minimize the operations that have to be performed in the close vicinity to the said signal source. For that the said signal, according to the diagram in Figure 10, might be at first compared with the sinusoidal reference function, then short pulses are generated at time instants of the said signal and the said function crossing instants and then these pulses are transmitted over wire, optical or radio communication channels to the place where the time instants of their appearing are converted into their digital time coordinates and this digital signal is filtered in the described way. Consequently, the operations that have to be performed closely to the said signal source are simple and they could be realized by simple technical means of low complexity with low power consumption.

The invented method can be used for digital filtering and parameter estimation of multiple analog signals [xl(t), x2(t), ... xp(t)]. For that the input signal analog/digital conversions are subdivided into two interconnected physically distanced levels as shown in Figure 10 and each of the input signals [x1(t), x2(t), ... xp(t)] is compared to generated sinusoidal reference function r(t) at the upper level. Pulses indicating crossings of the said signals with the said single reference function are generated as shown in Figure 6(c) in parallel. Then time-division multiplexing of the said pulses is realised and the pulses originating at different front-ends are sequentially transmitted to the lower level where their positions in time are marked digitally. The obtained set of the digital signals then is filtered in the time-division mode as described above. At least two benefits are achieved in this way. First, transmission of said pulses is better protected against influence of surrounding noise and, second, the number of signal sources connected to the system operating according to the invented method might be substantially larger than in the case of direct multiplexing of analog input signals.

Although the digital signal representing the original input signal is nonuniform, it can be converted into a sequence of periodically given sample values. To do that, the digital signal, given as a sequence of digitally timed signal and reference crossings {tk}, should be reconstructed by low-pass filtering performed according to the invented method.

Recovery of the original signal might be performed also in some other alternative ways. In particular, by performing direct and inverse Fourier transforms as explained above.

In the drawings there is shown an example of the invention and some additionally background informations. The drawings are showing in detail:

Fig. 1    is showing a diagram illustrating the prior art case,

Fig. 2    is showing a typical digital representation of analog signals. (a) sampled analog signal; (b) sequence of digital sample values representing the original analog signal,

Fig. 3    is showing an illustration of digital filtering performed according to the prior art,

Fig. 4    is showing a diagram illustrating the prior art in the case of filtering data acquired from a number of signal sources,

Fig. 5    is showing a diagram illustrating digital filtering of an analog signal performed according to the invented method,

Fig. 6    is showing a digital representation of an analog signal formed according to the invented method. (a) signal is compared with a sinusoidal reference function and the crossing points are detected; (b) sequence of the digital crossing time instants fully represents the original analog signal, assuming that the parameters of the reference function are given; (c) the crossing time instants might be represented also in an analog form as a sequence of properly timed pulses with short leading fronts,

Fig. 7      is showing a diagram illustrating filtering performed according to the invented method,

Fig. 8      is showing a zoomed up segment of a typical filtering template,

Fig. 9      is showing a forming for sample values (a, b, d and e) of the filter output signal indicated in (c),

Fig. 10     is showing a filtering of signals taken from a number of signal sources

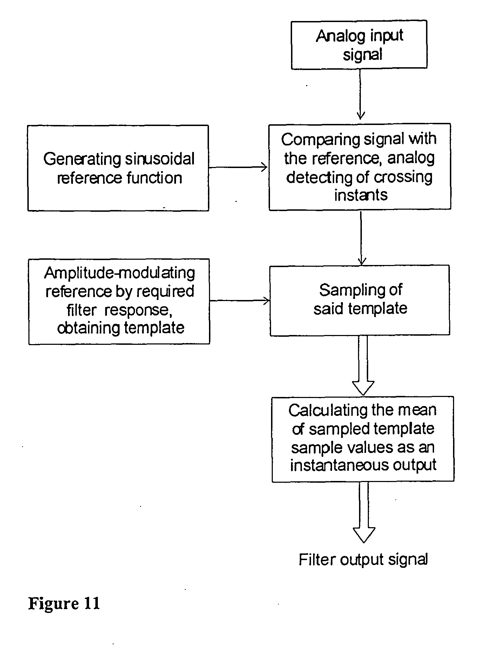

Fig. 11     is showing a digital filtering based on analog timing of the signal and the reference function crossings. The filter template is generated as an analog function, it is sampled at the crossing instants and the instantaneous filter output value is calculated as the mean value of the taken sample values of the template.

**Claims**

1.  A method for analog input signal digital filtering and parameter estimation comprising:

    (a) generating of a sinusoidal reference function of a given amplitude, phase angle and frequency outside the frequency range of the analog input signal to be digitally filtered;
    (b) comparing said input signal with said reference function and detecting the time instants of their crossings;
    (c) converting said time instants of the signal and reference crossings into their digital values and forming a digital signal as a sequence of digital said crossing instant values representing said input signal digitally;
    (d) generating a template for calculation of the filtered signal instantaneous values by amplitude-modulating the sinusoidal reference function with the required filter impulse response (according to the given expression (6)) as a tool for filtering out the input signal components within the required pass-band;
    (e) positioning said template so that its middle point coincides in time with the instantaneous value of the filter output signal to be calculated;
    (f) sampling of said properly positioned template at the time instants corresponding to the digital signal representation of said input signal;
    (g) calculating the respective instantaneous values of the filter output signal as the mean value of said sampled values of said template;
    (h) initiating the following cycles of filtering by shifting said template into the position for estimation the next output signal instantaneous value, sampling the template and averaging the sampled values of the template for obtaining the following instantaneous values of the filter output signal.

2.  The method of claim 1, wherein said method is adapted to on-line digital filtering of analog input signals and for that the said reference function is compared with said input signals, short pulses are formed at the time instants of the said reference function and input signal crossings, these pulse are transmitted to the central part of the system where said filtering template is sampled at time instants marked by said short pulses and filtering is carried out in accordance with the invented method.

3.  The method of claim 1, wherein said method is adapted to digital filtering of multiple analog input signals originating at remote signal sources and for that the said reference function is compared with all said input signals in parallel closely to the signal sources, short pulses are formed at the time instants of the said reference function and input signal crossings, these pulse are multiplexed in time-division way, transmitted to the central part of the system where digital signals representing the said input signals are formed and filtered in accordance with the invented method.

Figure 1

a)

b)

Figure 2

Figure 3

Remote signal sources

| Signal 1 | Signal 2 | - - - - | Signal n |

Multiplexing of analog signals

Analog-to-digital conversion

*Digital signal x(t_i)*

| Forming digial filter response | ⟹ | Multiplying sample values of signal and *h(t)* |

| Initiating next filtering cycle | ⟸ | Averaging of multiplied sample value pairs |

Filter output signal

Figure 4

Figure 5

a)

x(t)

Reference
sine-wave

signal

t

b)

t

Digital signal representing analog input

$t_1$   $t_2$   $t_3$   $t_4$   $t_5$   $t_6$   $t_7$   $t_8$   t

c)

t

Analog timing

$t_1$   $t_2$   $t_3$   $t_4$   $t_5$   $t_6$   $t_7$   $t_8$   t

**Figure 6**

Figure 7

**Figure 8**

Figure 9

Remote signal sources

```
┌─────────┐   ┌─────────┐            ┌─────────┐
│ Signal  │   │ Signal  │  ─ ─ ─ ─   │ Signal  │
│   1     │   │   2     │            │   n     │
└─────────┘   └─────────┘            └─────────┘
```

1 2 ┊ ┊ ┊ ┊  *n*

┌──────────────────────┐        ┌──────────────────────┐
│ Generating sinusoidal │ ──●──> │ Comparing signals with │
│  reference function    │       │  reference, analog     │
│                        │       │  detecting of crossing │
└──────────────────────┘        │       instsnts          │
                                 └──────────────────────┘

┌──────────────────────┐
│  Multiplexing pulse    │
│       streams          │
└──────────────────────┘

┌──────────────────────┐
│     Transmission       │
└──────────────────────┘

┌──────────────────────┐
│    Digital timing       │
│ of crossing events,     │
│  digital signal forming │
└──────────────────────┘

*Digital signal {t_i}*

┌──────────────────────┐        ┌──────────────────────┐
│   Forming filter        │ ──>  │  Sampling of said      │
│ template,positioning    │      │      template           │
└──────────────────────┘        └──────────────────────┘

┌──────────────────────┐        ┌──────────────────────┐
│   Initiating next       │ <──  │  Calculating the        │
│   filtering cycle       │      │ instantaneous output    │
└──────────────────────┘        │   signal values         │
                                 └──────────────────────┘

Filter output signal
```

**Figure 10**

Analog input signal

Generating sinusoidal reference function

Comparing signal with the reference, analog detecting of crossing instants

Amplitude-modulating reference by required filter response, obtaining template

Sampling of said template

Calculating the mean of sampled template sample values as an instantaneous output

Filter output signal

**Figure 11**

European Patent
Office

**EUROPEAN SEARCH REPORT**

Application Number

EP 07 02 1850

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 429 799 B1 (KAMAS LINDA ARGON [US] ET AL) 6 August 2002 (2002-08-06)<br>* column 5, line 17 - column 9, line 57; figures 1-3 *<br>----- | 1-3 | INV.<br>H03H17/02<br>H03M1/12 |
| A | US 5 630 425 A (PANESCU DORIN [US] ET AL) 20 May 1997 (1997-05-20)<br>* column 20, line 1 - column 24, line 27; figures 14a,14b *<br>----- | 1-3 | |

TECHNICAL FIELDS
SEARCHED (IPC)

H03H
H03M

The present search report has been drawn up for all claims

| Place of search | Date of completion of the search | Examiner |
|---|---|---|
| The Hague | 2 June 2008 | Lecoutre, Renaud |

EPO FORM 1503 03.82 (P04C01)

**ANNEX TO THE EUROPEAN SEARCH REPORT
ON EUROPEAN PATENT APPLICATION NO.**

EP 07 02 1850

This annex lists the patent family members relating to the patent documents cited in the above-mentioned European search report.
The members are as contained in the European Patent Office EDP file on
The European Patent Office is in no way liable for these particulars which are merely given for the purpose of information.

02-06-2008

| Patent document cited in search report | | Publication date | Patent family member(s) | | Publication date |
|---|---|---|---|---|---|
| US 6429799 | B1 | 06-08-2002 | DE | 10231155 A1 | 30-01-2003 |
| | | | JP | 4049630 B2 | 20-02-2008 |
| | | | JP | 2003124810 A | 25-04-2003 |
| US 5630425 | A | 20-05-1997 | NONE | | |

For more details about this annex : see Official Journal of the European Patent Office, No. 12/82